# EUROPEAN PATENT APPLICATION

(11) **EP 3 998 704 A1**
(43) Date of publication of application: **18.05.2022**
(21) Application number: 20836329.1
(22) Date of filing: 24.04.2020
(51) Int. Cl.: H03H 9/17

(54) **BULK ACOUSTIC RESONATOR, FILTER, AND ELECTRONIC DEVICE**

(30) Priority: 08.07.2019 CN 201910610938
(71) Applicant: Tianjin University, Tianjin 300072 (CN); Rofs Microsystem (Tianjin) Co., Ltd, Tianjin 300462 (CN)
(72) Inventor: ZHANG, Menglun, Tianjin 300072 (CN); PANG, Wei, Tianjin 300072 (CN); YANG, Qingrui, Tianjin 300072 (CN)
(74) Representative: Meyer-Dulheuer MD Legal Patentanwälte PartG mbB
(86) International application number: PCT/CN2020/086558
(87) International publication number: WO 2021/004127

(57) **Abstract**

A bulk acoustic resonator, comprising: a substrate; an acoustic mirror (30); a bottom electrode (10) disposed on the substrate and having a bottom electrode metal connection layer (13); a top electrode (12) opposite to the bottom electrode (10) and having a top electrode metal connection layer (14); and a piezoelectric layer (11) disposed on the bottom electrode (10) and between the bottom electrode (10) and the top electrode (12), wherein the overlapping region of the acoustic mirror (30), the bottom electrode (10), the piezoelectric layer (11), and the top electrode (12) in the thickness direction of the resonator constitutes the effective region of the resonator; the top electrode metal connection layer (14) and the bottom electrode metal connection layer (13) are arranged around 50% or more of the peripheral length of the effective region in total. Also provided are a filter and an electronic device having same.

## Description

### TECHNICAL FIELD

Embodiments of the present disclosure relate to the field of semiconductors, and in particular, to a bulk acoustic wave resonator, a filter having the resonator and an electronic device having the filter.

### BACKGROUND

A Film Bulk Acoustic Resonator (FBAR, also referred to as a Bulk Acoustic Wave Resonator (BAW)) is important in the field of communication as a MEMS chip. The traditional surface acoustic wave (SAW) filters and ceramic filters are gradually replaced by the FBAR filters since the FBAR filters have small size (µm level), high resonant frequency (GHz), high quality factor, large power capacity, good roll-off effect, and other excellent characteristics.

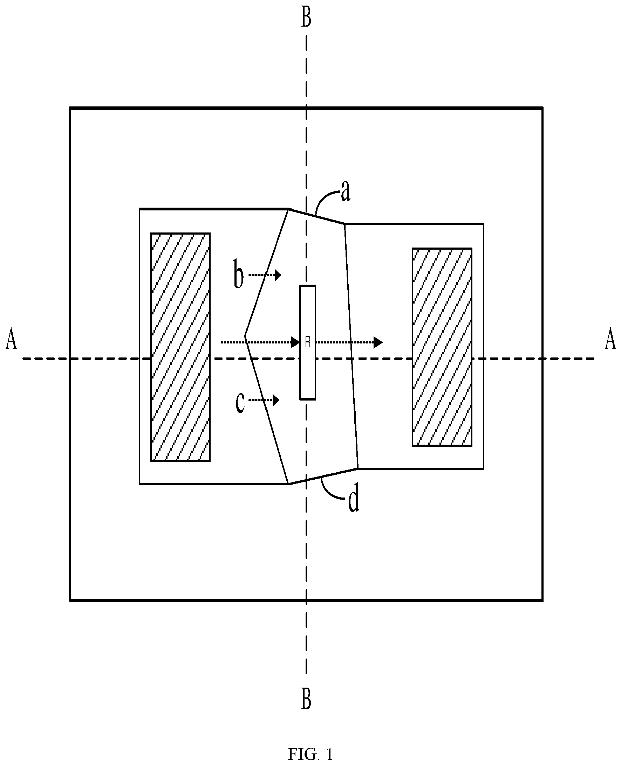

A structure of the conventional film bulk acoustic wave resonator is shown in FIG. 1. As shown in FIG. 1, reference numeral 10 represents a bottom electrode of the resonator, which is connected to two sides b and c of a pentagon of the resonator; reference numeral 11 represents a piezoelectric layer of the resonator, and reference numeral 12 represents a top electrode of the resonator, which is connected to a side of the pentagon of the resonator; and reference numerals 13 and 14 represent metal connection layers located above the bottom and top electrodes of the resonator, respectively. For the conventional film bulk acoustic resonator shown in FIG. 1, when a voltage is applied to the bottom electrode, a current can only flow from the two sides b and c of the pentagon of the resonator connected with the bottom electrode of the resonator. In this case, potentials across both sides b and c are same, but different from potentials across two sides a and d. After that, the current flows through an electrode resistor 15 to another side of the pentagon of the resonator connected with the top electrode of the resonator. Since the electrode is a thin film, the electrode has a larger resistance. In this way, an energy loss is large, which may result in a decrease in Q value of the resonator.

### SUMMARY

In order to alleviate or solve at least one aspect of the above problems in the related art, the present disclosure is provided. In the present disclosure, a series resistance Rs of a resonator is reduced by changing a connection between electrodes of the resonator and an effective region.

According to an aspect of embodiments of the present disclosure, there is provided a bulk acoustic wave resonator. The bulk acoustic wave resonator includes a substrate, an acoustic mirror, a bottom electrode provided above the substrate and having a bottom electrode metal connection layer, a top electrode arranged opposite to the bottom electrode and having a top electrode metal connection layer, and a piezoelectric layer provided above the bottom electrode and arranged between the bottom electrode and the top electrode. The acoustic mirror, the bottom electrode, the piezoelectric layer and the top electrode overlap each other in a thickness direction of the resonator to form an overlapping region which is defined as an effective region of the resonator. The top electrode metal connection layer and the bottom electrode metal connection layer are arranged around 50% or more of a peripheral length of the effective region in total.

Alternatively, the bottom electrode metal connection layer is arranged around at least a portion of the piezoelectric layer corresponding to the effective region.

Alternatively, the bottom electrode metal connection layer is provided with a first portion arranged on the bottom electrode and a second portion covering a part of an upper surface of the piezoelectric layer, and the second portion is spaced apart from the top electrode. Alternatively, the first portion is provided with a heat dissipation structure. Alternatively, the second portion and the top electrode are spaced apart from each other by a first distance in a projection in the thickness direction of the resonator. Alternatively, in a projection in the thickness direction of the resonator, the second portion is located at an outer side of an edge of the acoustic mirror and is spaced apart from the edge of the acoustic mirror by a second distance.

Alternatively, the top electrode metal connection layer and the bottom electrode metal connection layer are arranged around 90% or more of the peripheral length of the effective region.

Alternatively, the top electrode metal connection layer or the bottom electrode metal connection layer is arranged around 50% or more of the peripheral length of the effective region.

Alternatively, a portion of the top electrode metal connection layer surrounding the effective region and/or a portion of the bottom electrode metal connection layer surrounding the effective region has a width in a range of 1-50 µm, and further optionally in a range of 5-10 µm.

Alternatively, the top electrode metal connection layer is arranged around at least part of the effective region and is connected with the piezoelectric layer.

Alternatively, the top electrode metal connection layer is arranged around at least part of the effective region and is connected with the top electrode. Alternatively, the top electrode has a bridge structure surrounding at least part of the effective region, and the top electrode metal connection layer surrounds at least part of the bridge structure and is electrically connected to the bridge structure. Further alternatively, the top electrode metal connection layer is electrically connected to an outer edge of the bridge structure on an upper surface of the outer edge of the bridge structure.

Alternatively, the effective region has a polygonal shape. Further alternatively, the at least one of the top electrode metal connection layer and the bottom electrode metal connection layer arranged around at least part of the effective region includes one of the top electrode metal connection layer and the bottom electrode metal connection layer arranged around at least half of an edge of the effective region.

Alternatively, the polygonal shape includes a pentagonal shape, and the at least one of the top electrode metal connection layer and the bottom electrode metal connection layer arranged around at least part of the effective region includes one of the top electrode metal connection layer and the bottom electrode metal connection layer arranged substantially around at least three continuous sides of the polygonal shape. Further alternatively, the top electrode metal connection layer is arranged around four sides of the pentagonal shape, and the bottom electrode metal connection layer is arranged around the remaining side of the pentagonal shape; or the bottom electrode metal connection layer is arranged around four sides of the pentagonal shape, and the top electrode metal connection layer is arranged around the remaining side of the pentagonal shape; or the bottom electrode metal connection layer is arranged around substantially one half of the edge of the pentagonal shape, and the top electrode metal connection layer is arranged around another half of the edge of the pentagonal shape.

Alternatively, an end of the top electrode and an end of the bottom electrode partially overlap each other in a projection thereof in the thickness direction of the resonator.

Alternatively, the end of the top electrode and the end of the bottom electrode are spaced apart from each other by a third distance in the projection thereof in the thickness direction of the resonator. Optically, the third distance is greater than 5 µm.

According to another aspect of embodiments of the present disclosure, there is provided a bulk acoustic wave resonator. The bulk acoustic wave resonator includes a substrate, an acoustic mirror, a bottom electrode provided above the substrate and having a bottom electrode metal connection layer, a top electrode arranged opposite to the bottom electrode and having a top electrode metal connection layer, and a piezoelectric layer provided above the bottom electrode and arranged between the bottom electrode and the top electrode. The acoustic mirror, the bottom electrode, the piezoelectric layer and the top electrode overlap each other in a thickness direction of the resonator to form an overlapping region which is defined as an effective region of the resonator. At least one of the top electrode metal connection layer and the bottom electrode metal connection layer has a base connection portion and a surrounding portion, and the surrounding portion extends around at least part of the effective region from either sides or both sides of the base connection portion.

Alternatively, the surrounding portion is arranged around 50% or more of a peripheral length of the effective region.

Alternatively, the surrounding portion has a width in a range of 1-50 µm. Further, the width of the surrounding portion is in a range of 5-10 µm.

According to further another aspect of embodiments of the present disclosure, there is provided a filter including the bulk acoustic wave resonator as described above.

According to still another aspect of embodiments of the present disclosure, there is provided an electronic device including the filter or the bulk acoustic wave resonator as described above.

### BRIEF DESCRIPTION OF DRAWINGS

The following description and drawings can facilitate to understand these and other features and advantages in various embodiments disclosed in the present disclosure. The same reference signs in the drawings always indicate the same components, wherein:
FIG. 1 is a schematic top view of a bulk acoustic wave resonator in the related art;
FIG. 2 is a schematic top view of a bulk acoustic wave resonator according to an exemplary embodiment of the present disclosure;
FIG. 3 is a schematic exemplary partial enlarged view of part A in FIG. 2 according to an exemplary embodiment of the present disclosure;
FIG. 4 is a schematic view along line B-B in FIG. 2 according to an exemplary embodiment of the present disclosure;
FIG. 5 is a schematic view along line B-B in FIG. 2 according to another exemplary embodiment of the present disclosure;
FIG. 6 is a schematic view along line B-B in FIG. 2 according to yet another exemplary embodiment of the present disclosure;
FIG. 7 is a schematic top view of a bulk acoustic wave resonator according to an exemplary embodiment of the present disclosure;
FIG. 8 is a schematic exemplary partial enlarged view of part C in FIG. 7 according to an exemplary embodiment of the present disclosure;
FIG. 9 is a schematic top view of a bulk acoustic wave resonator according to an exemplary embodiment of the present disclosure;
FIG. 10 is a schematic exemplary enlarged partial view of part D in FIG. 9 according to an exemplary embodiment of the present disclosure;
FIG. 11 is a schematic view along line B-B in FIG. 9 according to an exemplary embodiment of the present disclosure; and
FIG. 12 is a schematic top view of a bulk acoustic wave resonator according to an exemplary embodiment of the present disclosure.

### DESCRIPTION OF EMBODIMENTS

The technical solutions of the present disclosure will be further described below in detail through embodiments and in conjunction with the drawings. The following description of the embodiments of the present disclosure with reference to the drawings is intended to explain the general inventive concept of the present disclosure, and should not be construed as a limitation to the present disclosure.

Hereinafter, a bulk acoustic wave resonator according to embodiments of the present disclosure will be described with reference to the drawings. It should be noted that, in the embodiments of the present disclosure, although a film bulk acoustic wave resonator is described as an example, these descriptions can be applicable to other types of bulk acoustic wave resonators.

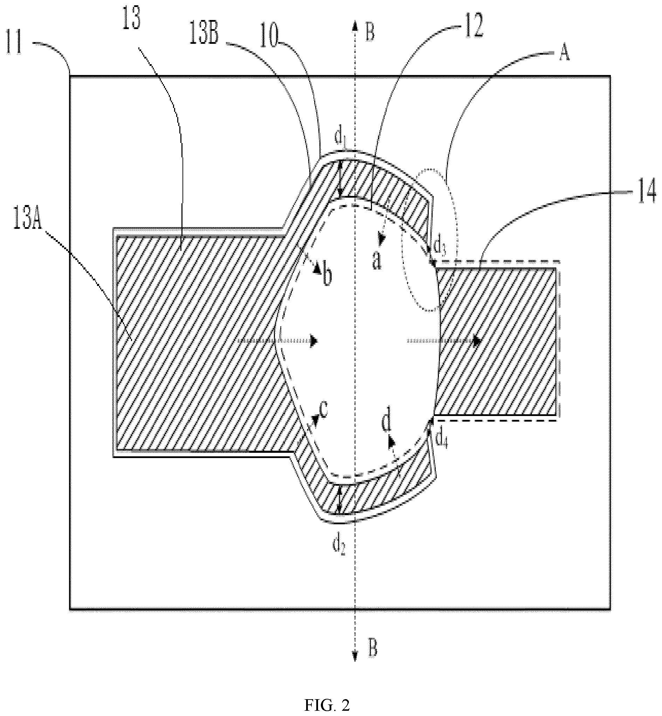

FIG. 2 is a schematic top view of a bulk acoustic wave resonator according to an exemplary embodiment of the present disclosure.

In the embodiment shown in FIG. 2, reference numeral 10 represents a bottom electrode of the resonator, and the bottom electrode is connected with four sides of a pentagon (defined as an effective region) of the resonator; reference numeral 11 represents a piezoelectric layer of the resonator; reference numeral 12 represents a top electrode of the resonator; reference numeral 13 represents a bottom electrode metal connection layer above the bottom electrode of the resonator; and reference numeral 14 represents a top electrode metal connection layer above the top electrode of the resonator. Portions of the bottom electrode metal connection layer surrounding edge portions of the effective region have widths d₁ and d₂. Values of d₁ and d₂ may be equal or unequal to each other, generally are in a range of 1-50 µm, and typically are in a range of 5-10 µm, and may also be 20 µm or 7 µm except for end values of the above ranges. The bottom electrode metal connection layer and the top electrode metal connection layer each have a thickness which is generally in a range of 100 nm to 5 µm, and may also be for example 1 µm except for the end values of the above ranges.

In this embodiment, as shown in FIG. 2, the four sides of the pentagon of the resonator are connected with the bottom electrode metal connection layer. Accordingly, when a voltage is applied to the bottom electrode of the resonator, a same potential is generated across the four sides a, b, c, and d of the pentagon of the resonator connected with the bottom electrode due to an extremely high conductivity of the bottom electrode metal connection layer. A current flows in from four sides of the bottom electrode. Thus, when the resonator operates, its resistance Rs (series resistance) is decreased, i.e., an electrical energy loss of the electrodes is reduced, so that a Q value of the resonator is improved and an IL value (insertion loss value) of the filter, which is composed of the electrodes, are also improved. Meanwhile, since the edges of the effective region of the resonator has the same potential, a main acoustic resonance mode is superior such that a parasitic mode is suppressed from being generated. On the contrary, the potentials of edges of the effective region of the conventional resonator are different from each other, resulting in inconsistent vibration of each part of the resonator, and thus the parasitic mode is enhanced.

Further, since the bottom electrode metal connection layer located above the bottom electrode also uniformly covers the periphery of the pentagon of the resonator and the metal has good heat dissipation performance, a thermal resistance in the resonator is effectively reduced. Accordingly, a power capacity of the resonator is improved.

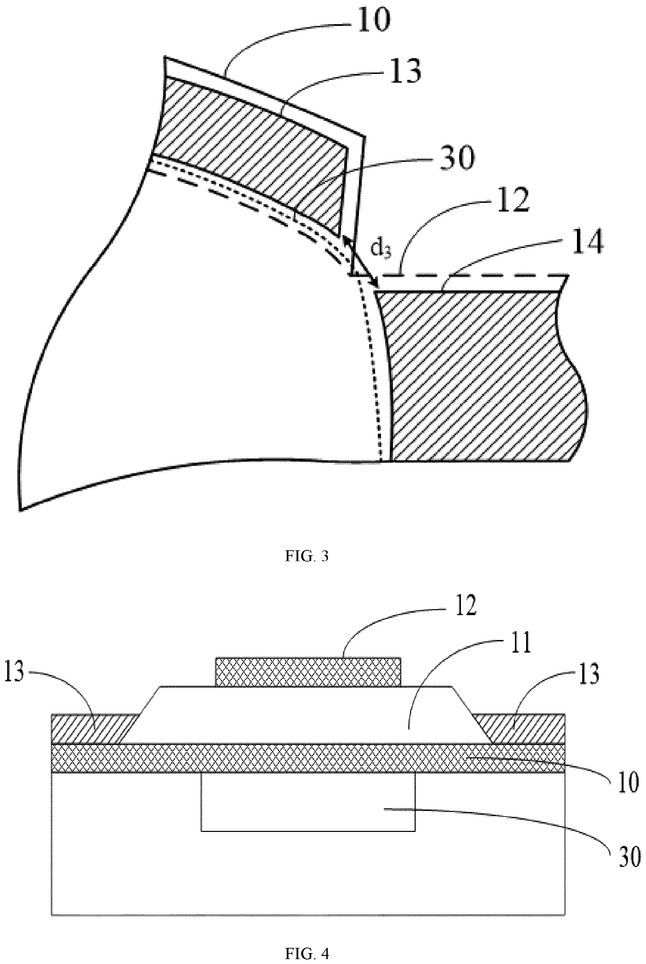

FIG. 3 is a schematic exemplary partial enlarged view of part A (where an end of the top electrode is adjacent to an end of the bottom electrode) in FIG. 2 according to an exemplary embodiment of the present disclosure. Reference numeral 10 represents the bottom electrode, reference numeral 12 represents the top electrode, reference numeral 13 represents the bottom electrode metal connection layer above the bottom electrode, reference numeral 14 represents the top electrode metal connection layer above the top electrode, and reference numeral 30 represents a cavity structure at a bottom of the resonator. A distance d₃ is formed between the metal connection layers 13 and 14 to avoid a short circuit caused by contact between the top electrode metal connection layer and the bottom electrode metal connection layer, and a value of the distance d₃ may be greater than 5 µm.

FIG. 4 is a schematic view along line B-B in FIG. 2 according to an exemplary embodiment of the present disclosure. In FIG. 4, the resonator is sequentially provided with the following elements in a vertical direction: an acoustic mirror structure 30, which may be a cavity structure etched in a substrate or a cavity structure protruding upwardly, or may be in an acoustic wave reflection form such as a Bragg reflection structure, and is the cavity structure etched in the substrate in FIG. 4; the bottom electrode 10; the piezoelectric layer 11; the top electrode 12; and the bottom electrode metal connection layer 13 disposed above the bottom electrode, in which portions of the bottom electrode metal connection layer surrounding the edges of the effective region have widths d₁ and d₂. The values of d₁ and d₂ may be equal or unequal to each other, generally are in a range of 1-50 µm, and typically are in a range of 5-10 µm, and the bottom electrode metal connection layer generally has a thickness of 100 nm-5 µm.

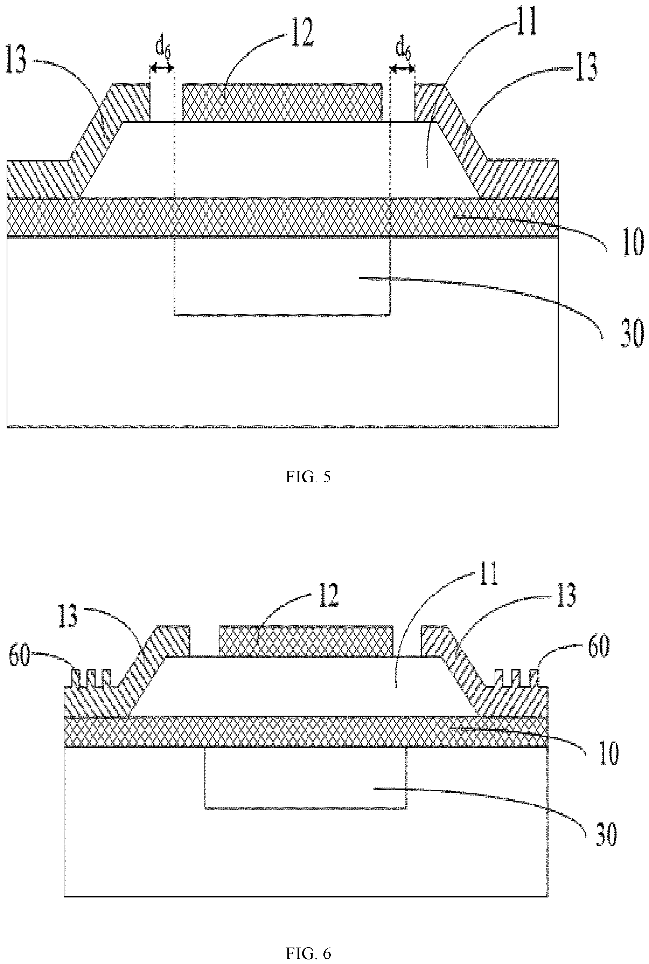

FIG. 5 is a schematic view along line B-B in FIG. 2 according to another exemplary embodiment of the present disclosure. The structure shown in FIG. 5 is similar to that shown in FIG. 4 except that the bottom electrode metal connection layer connected with the pentagon of the resonator in FIG. 5 covers a portion of the piezoelectric layer 11 across steps and is vertically spaced apart from edges of the cavity structure by a spacing d₆, a value of which is greater than zero. In this way, a region covered by the metal connection layer is increased, which in turn increases heat dissipation function to effectively reduce the thermal resistance in the resonator. Accordingly, the power capacity of the resonator is further improved.

FIG. 6 is a schematic view along line B-B in FIG. 2 according to another exemplary embodiment of the present disclosure. The structure shown in FIG. 6 is similar to that shown in FIG. 5 except that a plurality of bumps is arranged on the bottom electrode metal connection layer to further improve the heat dissipation performance and reduce the thermal resistance in the resonator, so that the power capacity of the resonator is further improved. The heat dissipation structure is not limited to the bumps shown in FIG. 6, and may be a rib structure or other structures facilitating to increase the heat dissipation area.

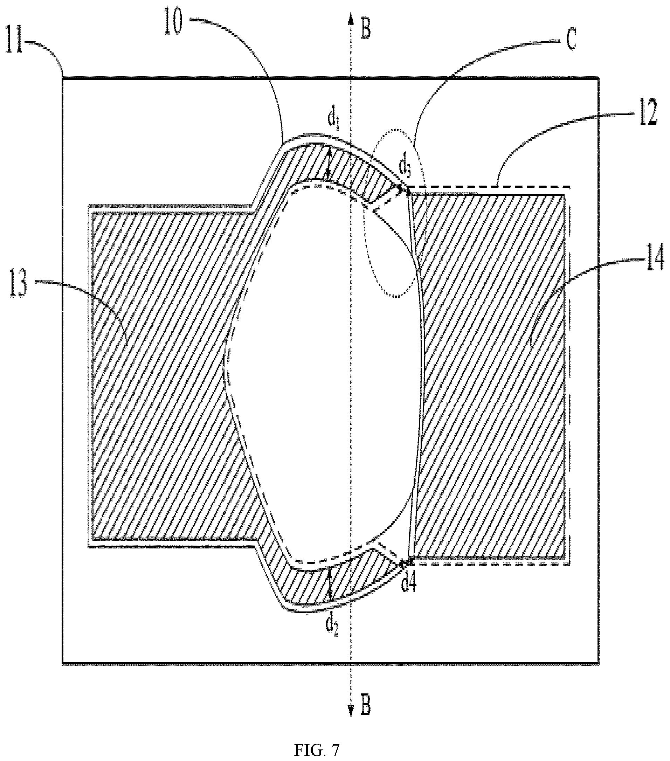

FIG. 7 is a schematic top view of a bulk acoustic wave resonator according to an exemplary embodiment of the present disclosure. The structure shown in FIG. 7 is similar to that shown in FIG. 2, except that the bottom electrode metal connection layer 13 and the top electrode metal connection layer 14 only partially cover the bottom electrode 10 and the top electrode 12. Meanwhile, a portion of the end of the bottom electrode 10 vertically overlaps the top electrode 12 to increase a mechanical strength of the resonator at corners, so that the structure of the resonator is more stable.

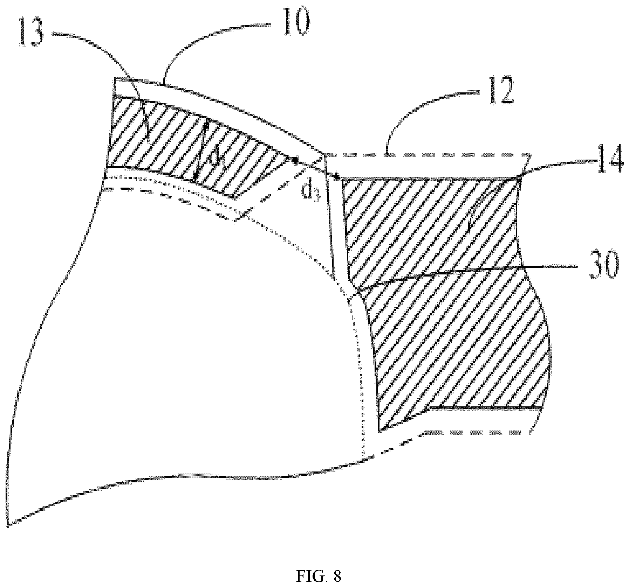

FIG. 8 is a schematic exemplary partial enlarged view of part C in FIG. 7 according to an exemplary embodiment of the present disclosure, wherein reference numeral 10 represents the bottom electrode, reference numeral 12 represents the top electrode, reference numeral 30 represents the cavity structure, reference numeral 13 represents the bottom electrode metal connection layer above the bottom electrode, and reference numeral 14 represents the top electrode metal connection layer above the top electrode. In this embodiment, the bottom electrode and the top electrode overlap each other in a vertical direction at their boundary connections. In this way, since overlapped potions are located at the corners, the mechanical strength of the resonator at the corners is increased so that the structure of the resonator is more stable.

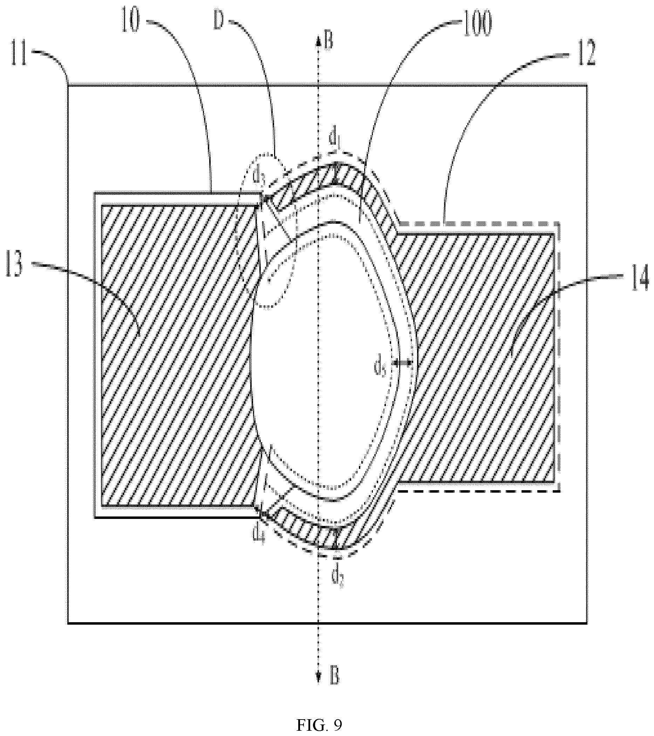

FIG. 9 is a schematic top view of a bulk acoustic wave resonator according to an exemplary embodiment of the present disclosure. The structure shown in FIG. 9 is similar to that shown in FIG. 7, except that the top electrode of the resonator is connected to the four sides of the pentagon of the resonator. Further, portions of the top electrode metal connection layer arranged above the top electrode surrounds the edges of the pentagon of the resonator and have widths d₁ and d₂. The values of d₁ and d₂ may be equal or unequal to each other, generally are in a range of 1-50 µm, and typically are in a range of 5-10 µm, and the top electrode metal connection layer generally has a thickness which is generally in a range of 100 nm to 5 µm. Moreover, a bridge structure 100 is provided between an edge of the top electrode and the pentagon of the resonator. The bridge structure spans a boundary of the cavity structure, and has a width d₅, which may be typically 5 µm. Since an acoustic impedance of the bridge structure does not match with that in the effective region of the resonator due to an air gap at the bridge structure, an acoustic wave transmission at the boundary is discontinuous. Thus, a part of acoustic energy at the boundary will be coupled and reflected to an effective excitation region and is then converted into a piston acoustic wave mode perpendicular to a surface of the piezoelectric layer, so that a Q factor of the resonator is improved.

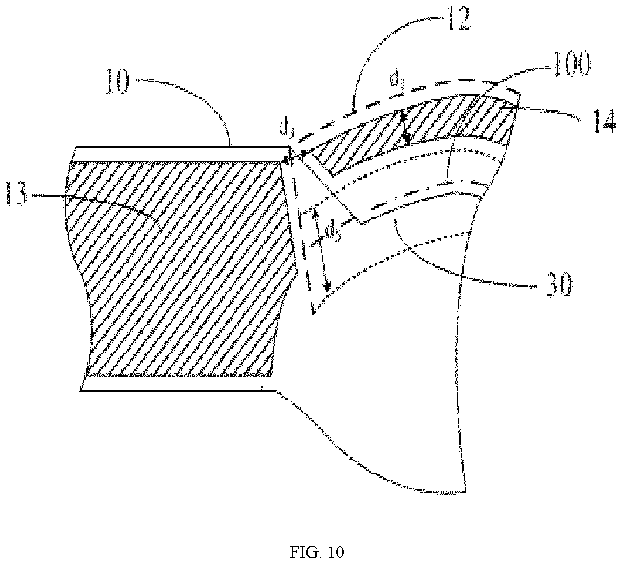

FIG. 10 is a schematic exemplary enlarged partial view of part D in FIG. 9 according to an exemplary embodiment of the present disclosure. Reference numeral 10 represents the bottom electrode, reference numeral 12 represents the top electrode, reference numeral 30 represents the cavity structure, reference numeral 13 represents the bottom electrode metal connection layer above the bottom electrode, reference numeral 14 represents the top electrode metal connection layer above the top electrode, and reference numeral 100 represents the bridge structure. In this embodiment, since the bridge structure is formed between the edge of the top electrode and the edges of the pentagon of the resonator, the acoustic wave energy in the resonator is limited within its effective region such that the Q value of the resonator is improved.

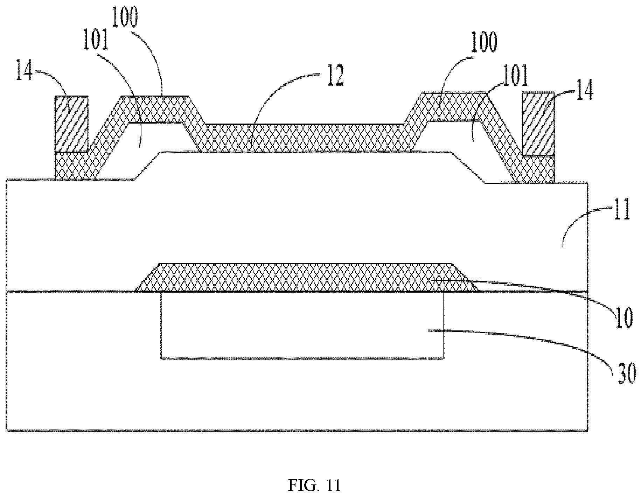

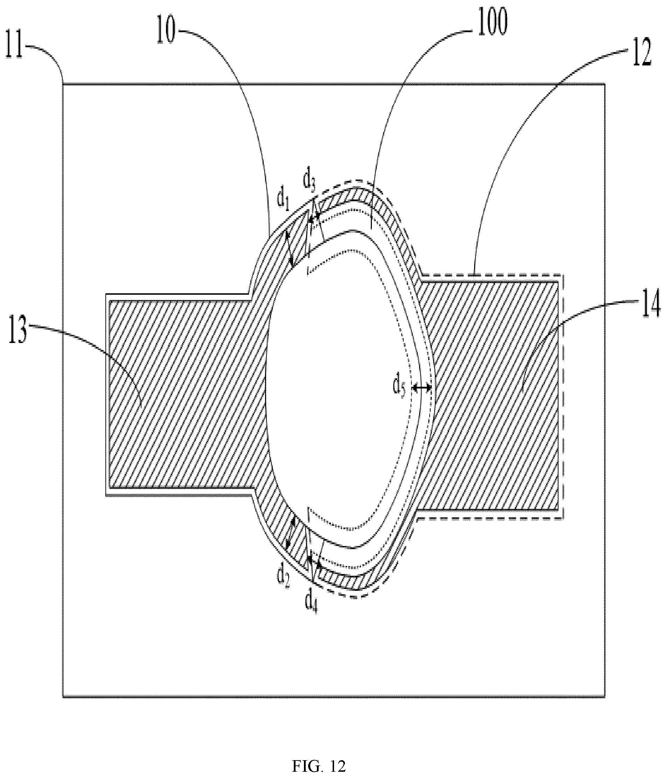

FIG. 11 is a schematic view along line B-B in FIG. 9 according to an exemplary embodiment of the present disclosure. In FIG. 11 , the resonator is sequentially provided with the following elements in the vertical direction: the acoustic mirror structure 30, which may be a cavity structure etched in the substrate or a cavity structure protruding upwardly, or may be in an acoustic wave reflection form such as a Bragg reflection structure, and is the cavity structure etched in the substrate in FIG. 12; the bottom electrode 10; the piezoelectric layer 11; the top electrode 12; the bridge structure 100; the air gap 101 located between the bridge structure and the piezoelectric layer; and the top electrode metal connection layer 14. Portions of the top electrode metal connection layer surrounding the edges of the pentagon have widths d₁ and d₂, of which the values may be equal or unequal to each other, generally are in a range of 1-50 µm, and typically is in a range of 5-10 µm, and the top electrode metal connection layer has a thickness of 100 nm-5 µm.

It should be noted that, although not shown, the top electrode may not be provided with the bridge structure, and the top electrode metal connection layer is directly connected to the edges of the top electrode.

FIG. 12 is a schematic top view of a bulk acoustic wave resonator according to an exemplary embodiment of the present disclosure. The structure shown in FIG. 12 is similar to that shown in FIG. 9, except that the bottom and top electrodes of the resonator are both connected to the sides of the pentagon of the resonator, and the edges of the top electrode metal connection layer located above the bottom and top electrodes are spaced apart from the sides of the pentagon by spacings d₁ and d₂, respectively. The values of d₁ and d₂ may be equal or unequal to each other, generally are in a range of 1-50 µm, and typically are in a range of 5-10 µm, and the top electrode metal connection layer generally has a thickness of 100 nm-5 µm.

In the present disclosure, the top electrode metal connection layer or the bottom electrode metal connection layer is arranged around 50% or more of a peripheral length of the effective region, or the two metal connection layers are arranged around 50% or more of the peripheral length of the effective region in total.

It should be noted that, in the exemplary embodiment of the present disclosure, the effective region of the pentagonal shape is described as an example. However, the present disclosure is not limited thereto, and the effective region may also be in other shapes.

In the present disclosure, it can be understood that the metal connection layer may include a base connection portion (e.g., a base connection portion 13A of the bottom electrode metal connection layer 13 in FIG. 2) and a surrounding portion extending around the effective region from a side of the base connection portion (for example, the surrounding portion 13A of the bottom electrode metal connection layer in FIG. 2). Obviously, the surrounding portion may be disposed at either side or both sides of the base connection portion.

In the present disclosure, the electrode metal connection layers may be made of gold(Au), aluminum(Al), copper(Cu), silver(Ag), or similar materials with good conductivity. The top electrode and the bottom electrode may be made of Tungsten(W), molybdenum(Mo), platinum(Pt), ruthenium(Ru), iridium(Ir), titanium tungsten(TiW), aluminum(Al), titanium(Ti), and other similar metals. The piezoelectric layer material may be made of aluminum nitride(AlN), zinc oxide(ZnO), lead zirconate titanate(PZT), lithium niobate(LiNbO₃), quartz(Quartz), potassium niobate (KNbO₃) or lithium tantalate(LiTaO₃), or other similar materials.

In view of the above description, there is provided a bulk acoustic wave resonator, including:
a substrate;
an acoustic mirror;
a bottom electrode provided above the substrate and having a bottom electrode metal connection layer;
a top electrode arranged opposite to the bottom electrode and having a top electrode metal connection layer; and
a piezoelectric layer provided above the bottom electrode and arranged between the bottom electrode and the top electrode,
wherein:
   the acoustic mirror, the bottom electrode, the piezoelectric layer and the top electrode overlap each other in a thickness direction of the resonator to form an overlapping region which is defined as an effective region of the resonator; and
   the top electrode metal connection layer and the bottom electrode metal connection layer are arranged around 50% or more of a peripheral length of the effective region in total.

It should be noted that, in the present disclosure, "the top electrode metal connection layer and the bottom electrode metal connection layer are arranged around...in total" includes a situation where the metal connection layers are both arranged partially around the effective region (for example, see FIG. 12), a situation where one of the metal connection layers only extends towards but not around the effective region and the other metal connection layer is arranged around the effective region (for example, see FIG. 2 where the top electrode metal connection layer may be shown to have a smaller width), and a situation where one of the metal connection layers does not extend near the effective region (for example, the bottom electrode metal connection layer shown in FIG. 1) and the other metal connection layer is arranged around the effective region.

Further, one of the top electrode metal connection layer and the bottom electrode metal connection layer is arranged around 90% or more of the peripheral length of the effective region.

Further, the top electrode metal connection layer or the bottom electrode metal connection layer is arranged around 50% or more of the peripheral length of the effective region.

Further, a portion of the top electrode metal connection layer and/or the bottom electrode metal connection layer surrounding the effective region has a width which is in a range of 1-50 µm.

In addition, there is also provided a bulk acoustic wave resonator, including:
a substrate;
an acoustic mirror;
a bottom electrode provided above the substrate and having a bottom electrode metal connection layer;
a top electrode arranged opposite to the bottom electrode and having a top electrode metal connection layer; and
a piezoelectric layer provided above the bottom electrode and arranged between the bottom electrode and the top electrode,
wherein:
   the acoustic mirror, the bottom electrode, the piezoelectric layer and the top electrode overlap each other in a thickness direction of the resonator to form an overlapping region which is defined as an effective region of the resonator;
   at least one of the top electrode metal connection layer and the bottom electrode metal connection layer has a base connection portion and a surrounding portion extending around at least part of the effective region from either side or both sides of the base connection portion. Alternatively, the surrounding portion is arranged around 50% or more of a peripheral length of the effective region. Alternatively, the surrounding portion has a width which is in a range of 1-50 µm. Further, the width of the surrounding portion is in a range of 5-10 µm.

Based on the above, the present disclosure further provides a filter including a plurality of the bulk acoustic wave resonators as described above. The present disclosure also provides an electronic device including the filter or the bulk acoustic wave resonator as described above.

Although the embodiments of the present disclosure have been shown and described, it can be understood for those skilled in the art that modifications can be made to these embodiments without departing from the principle and spirit of the present disclosure, and the scope of the present disclosure is defined by the appended claims and their equivalents.

## Claims

1. A bulk acoustic wave resonator, comprising:
a substrate;
an acoustic mirror;
a bottom electrode provided above the substrate and having a bottom electrode metal connection layer;
a top electrode arranged opposite to the bottom electrode and having a top electrode metal connection layer; and
a piezoelectric layer provided above the bottom electrode and arranged between the bottom electrode and the top electrode,
**characterized in that**,
the acoustic mirror, the bottom electrode, the piezoelectric layer and the top electrode overlap each other in a thickness direction of the resonator to form an overlapping region, and the overlapping region is defined as an effective region of the resonator; and
the top electrode metal connection layer and the bottom electrode metal connection layer are arranged around 50% or more of a peripheral length of the effective region in total.

2. The resonator according to claim 1, **characterized in that** the bottom electrode metal connection layer is arranged around at least a portion of the piezoelectric layer corresponding to the effective region.

3. The resonator according to claim 2, **characterized in that** a thickness of the bottom electrode metal connection layer is the same as a thickness of the piezoelectric layer.

4. The resonator according to claim 2, **characterized in that** the bottom electrode metal connection layer is provided with a first portion arranged on the bottom electrode and a second portion covering a part of an upper surface of the piezoelectric layer, and the second portion is spaced apart from the top electrode.

5. The resonator according to claim 4, **characterized in that** the first portion is provided with a heat dissipation structure.

6. The resonator according to claim 4, **characterized in that** in a projection in the thickness direction of the resonator, the second portion and the top electrode are spaced apart from each other by a first distance.

7. The resonator according to claim 4, **characterized in that** in a projection in the thickness direction of the resonator, the second portion is located at an outer side of an edge of the acoustic mirror, and is spaced apart from the edge of the acoustic mirror by a second distance (d₆).

8. The resonator according to claim 1, **characterized in that** the top electrode metal connection layer and the bottom electrode metal connection layer are arranged around 90% or more of the peripheral length of the effective region in total.

9. The resonator according to claim 1, **characterized in that** the top electrode metal connection layer or the bottom electrode metal connection layer is arranged around 50% or more of the peripheral length of the effective region.

10. The resonator according to claim 1, **characterized in that** a portion of the top electrode metal connection layer surrounding the effective region and/or a portion of the bottom electrode metal connection layer surrounding the effective region has a width in a range of 1-50 µm.

11. The resonator according to claim 10, **characterized in that** the width of the portion of the top electrode metal connection layer surrounding the effective region and/or the width of the portion of the bottom electrode metal connection layer surrounding the effective region is in a range of 5-10 µm.

12. The resonator according to any one of claims 1 to 11, **characterized in that** the top electrode metal connection layer is arranged around at least part of the effective region and is connected with the piezoelectric layer.

13. The resonator according to any one of claims 1 to 11, **characterized in that** the top electrode metal connection layer is arranged around at least part of the effective region and is connected with the top electrode.

14. The resonator according to claim 13, **characterized in that** the top electrode is provided with a bridge structure surrounding at least part of the effective region; and
the top electrode metal connection layer surrounds at least part of the bridge structure and is electrically connected to the bridge structure.

15. The resonator according to claim 14, **characterized in that** the top electrode metal connection layer is electrically connected to an outer edge of the bridge structure on an upper surface of the outer edge of the bridge structure.

16. The resonator according to any one of claims 1 to 15, **characterized in that** the effective region has a polygonal shape.

17. The resonator according to claim 16, **characterized in that** the at least one of the top electrode metal connection layer and the bottom electrode metal connection layer arranged around at least part of the effective region comprises one of the top electrode metal connection layer and the bottom electrode metal connection layer arranged around at least half of an edge of the effective region.

18. The resonator according to claim 17, **characterized in that** the polygonal shape comprises a pentagonal shape; and
the at least one of the top electrode metal connection layer and the bottom electrode metal connection layer arranged around at least part of the effective region comprises one of the top electrode metal connection layer and the bottom electrode metal connection layer arranged substantially around at least three continuous sides of the polygonal shape.

19. The resonator according to claim 18, **characterized in that** the top electrode metal connection layer is arranged around four sides of the pentagonal shape, and the bottom electrode metal connection layer is arranged around the remaining side of the pentagonal shape; or
the bottom electrode metal connection layer is arranged around four sides of the pentagonal shape, and the top electrode metal connection layer is arranged around the remaining side of the pentagonal shape; or
the bottom electrode metal connection layer is arranged around substantially one half of an edge of the pentagonal shape, and the top electrode metal connection layer is arranged around another half of the edge of the pentagonal shape.

20. The resonator according to any one of claims 1 to 19, **characterized in that** an end of the top electrode and an end of the bottom electrode partially overlap each other in a projection thereof in the thickness direction of the resonator.

21. The resonator according to any one of claims 1 to 19, **characterized in that** an end of the top electrode and an end of the bottom electrode are spaced apart from each other by a third distance (d₃) in a projection thereof in the thickness direction of the resonator.

22. The resonator according to claim 21, **characterized in that** the third distance is greater than 5 µm.

23. A bulk acoustic wave resonator, comprising:
a substrate;
an acoustic mirror;
a bottom electrode provided above the substrate and having a bottom electrode metal connection layer;
a top electrode arranged opposite to the bottom electrode and having a top electrode metal connection layer; and
a piezoelectric layer provided above the bottom electrode and arranged between the bottom electrode and the top electrode,
**characterized in that**,
the acoustic mirror, the bottom electrode, the piezoelectric layer and the top electrode overlap each other in a thickness direction of the resonator to form an overlapping region which is defined as an effective region of the resonator; and
at least one of the top electrode metal connection layer and the bottom electrode metal connection layer has a base connection portion and a surrounding portion, and the surrounding portion extends around at least part of the effective region from either sides or both sides of the base connection portion.

24. The resonator according to claim 23, **characterized in that** the surrounding portion is arranged around 50% or more of a peripheral length of the effective region.

25. The resonator according to claim 23, **characterized in that** the surrounding portion has a width in a range of 1-50 µm.

26. The resonator according to claim 25, **characterized in that** the width of the surrounding portion is in a range of 5-10 µm.

27. A filter comprising the bulk acoustic wave resonator according to any one of claims 1 to 26.

28. An electronic device comprising the filter according to claim 27 or the bulk acoustic wave resonator according to any one of claims 1 to 26.
